# EUROPÄISCHE PATENTSCHRIFT

(11) **EP 3 250 890 B1**
(45) Veröffentlichungstag und Bekanntmachung des Hinweises auf die Patenterteilung: **26.05.2021**
(21) Anmeldenummer: 15805547.5
(22) Anmeldetag: 09.12.2015
(51) Int. Cl.: G01D 5/14, G01R 33/00, G01R 33/038

(54) **MAGNET-BASIERTES DREHWINKELMESSSYSTEM**
MAGNET-BASED ANGULAR DISPLACEMENT MEASURING SYSTEM
SYSTÈME MAGNÉTIQUE DE MESURE D'ANGLE DE ROTATION

(30) Priorität: 28.01.2015 DE 102015101246
(43) Veröffentlichungstag der Anmeldung: 06.12.2017
(73) Patentinhaber: Fraba B.V., 6416 SG Heerlen (NL)
(72) Erfinder: FORTHAUS, Martin, 50829 Köln (DE)
(74) Vertreter: terpatent Patentanwälte ter Smitten Eberlein-Van Hoof Rütten Daubert
(86) Internationale Anmeldenummer: PCT/EP2015/079132
(87) Internationale Veröffentlichungsnummer: WO 2016/119963

(56) Entgegenhaltungen:
- EP-A2- 1 061 341
- EP-A2- 1 128 159
- DE-A1- 3 324 872
- DE-A1-102007 034 099
- DE-A1-102013 217 428
- US-A1- 2011 127 997
- US-A1- 2013 241 538

## Beschreibung

Die Erfindung betrifft ein Magnet-basiertes Drehwinkelmesssystem zum Erfassen einer Drehbewegung einer Antriebswelle, mit einer Antriebswelle, die einen axialen ersten Wellenendbereich aufweist, einer an dem ersten Wellenendbereich mit der Antriebswelle drehfest verbundenen Erregereinheit, und einer feststehenden Sensoreinheit, die zum Erfassen einer Drehbewegung der Antriebswelle mit der Erregereinheit funktional zusammenwirkt.

Derartige Drehwinkelmesssysteme dienen zur Messung von Drehbewegungen einer Welle und werden vielfach auch als Winkelmesseinrichtung, Drehwinkelsensor oder Drehgeber bezeichnet. Sie werden insbesondere zur Steuerung und Überwachung von Maschinen und Fahrzeugen eingesetzt. Eine besondere Rolle spielen dabei kontaktfreie Drehwinkelmesssysteme, beispielsweise elektrisch oder magnetisch induzierte Systeme, da sie aufgrund der verschleissfreien Sensorik eine lange Lebensdauer haben. Bei Magnet-basierten Drehwinkelmesssystemen, insbesondere bei magnetischen Multiturn-Absolutwertgebern, wird die Umdrehung einer Welle mittels einer Messeinheit induktiv erfasst, wobei die Messeinheit insbesondere eine rotierende Erregereinheit, wie einen Permanentmagnet, und eine feststehende Sensoreinheit mit zumindest einem Sensor, wie beispielsweise einem Hall- und/oder Wiegand-Sensor, umfasst. Hierzu ist die Messeinheit zumeist an dem axialen ersten Wellenendbereich bzw. an dem freien Ende der zu überwachenden Welle angeordnet.

Bei der Anordnung bzw. dem Anbau eines Magnet-basierten Drehwinkelmesssystems unmittelbar an eine Antriebswelle, insbesondere an eine Antriebswelle eines Elektromotors/-generators oder einer magnetischen Bremse, treten jedoch häufig geringe Messfehler auf. Solche Messfehler sind zumeist durch von außen auf das Drehwinkelmesssystem einwirkende Störgrößen verursacht. Eine solche Störgröße ist beispielsweise ein Magnetfeld, das dadurch hervorgerufen ist, dass die Antriebswelle im Betrieb von dem Elektromotor oder von einer elektromagnetischen Bremse magnetisiert wird und das Magnetfeld durch die typischerweise aus Stahl hergestellte Welle weitergeleitet wird und schließlich an dem Drehwinkelmesssystem das durch die Erregereinheit gebildete rotatorische Magnetfeld verändert, so dass in der Sensoreinheit Messfehler verursacht werden. Zur Verbesserung der Messgenauigkeit ist daher eine Vermeidung solcher Störungen in dem Drehwinkelmesssystem erforderlich.

Aus der DE 38 13 610 A1 ist eine Winkelmesseinrichtung mit einer Abtasteinrichtung bekannt, bei der die Abtasteinrichtung gegenüber elektrischen Störeinflüssen abgeschirmt ist. Dazu ist die Abtasteinrichtung in einem Gehäuse elektrisch isoliert befestigt und mit dem Massepotential einer Auswerteeinheit verbunden. Zudem steht das Gehäuse mit der Antriebseinheit in elektrischen Kontakt, so dass die von der Ansteuerung der Antriebseinheit ausgehenden Störsignale keine nachteiligen Auswirkungen auf die Messwerte haben.

Ähnliche Winkelmesseinrichtungen sind auch aus den Druckschriften EP 1 061 341 A2, DE 10 2007 034 099 A1, US 2013/241538 A1 und US 2011/127997 A1 bekannt.

Nachteilig hierbei ist jedoch, dass magnetisch induzierte Störeinflüsse nicht abgeschirmt sind und dadurch insbesondere bei Magnet-basierten Winkelmesseinrichtungen in der Sensoreinheit nach wie vor Messfehler verursacht werden. Darüber hinaus ist die Einrichtung zur Abschirmung der Winkelmesseinrichtung sehr komplex aufgebaut und umfasst eine Vielzahl von Bauteilen. Hierzu ist es aus der gattungsgemäßen EP 1 128 159 A2 bekannt, im Wellenendbereich der Antriebswelle eine Ausnehmung vorzusehen, die mit Kupferblech, also einem nicht-ferromagnetisch leitenden Material, ausgekleidet ist. Diese Vorgehensweise ist sehr aufwendig und damit teuer. Darüber hinaus ist eine derartige Anordnung auch nicht für alle Erregereinheiten geeignet, da diese hinsichtlich der Größe auf jeden Fall in die Auskleidung des Wellenendbereiches passen müssen.

Aus der DE 10 2013 217 428 A1 ist es bekannt, eine Erregereinheit über eine Befestigungseinrichtung, die aus einem magnetisch nur gering-leitfähigen Material hergestellt ist, an einer Antriebswelle zu befestigen. Durch die magnetisch nur gering-leitfähige Befestigungseinrichtung soll der Einfluss eines in der Antriebswelle vorhandenen Magnetfelds auf eine Sensoreinheit verringert werden. Da die Sensoreinheit jedoch in relativ geringem Abstand zu einem axialen Ende der magnetisch leitfähigen Antriebswelle angeordnet ist, kann eine Beeinträchtigung der Sensoreinheit durch das in der Antriebswelle vorhandene Magnetfeld nicht zuverlässig vermieden werden.

Der Erfindung liegt daher die Aufgabe zugrunde, ein Drehwinkelmesssystem zum Erfassen einer Drehbewegung einer Antriebswelle bereitzustellen, das eine exakte und störungsfreie Messung, einen kompakten Aufbau und eine unkomplizierte Montage ermöglicht.

Die Lösung der Aufgabe erfolgt erfindungsgemäß durch ein Drehwinkelmesssystem mit den Merkmalen des Anspruchs 1.

Das erfindungsgemäße Drehwinkelmesssystem umfasst eine Antriebswelle, die zumindest zweistückig ausgebildet ist und die ein separat ausgebildetes erstes Wellenteilstück, ein separat ausgebildetes zweites Wellenteilstück und einen axialen ersten Wellenendbereich aufweist, wobei der erste Wellenendbereich durch das erste Wellenteilstück gebildet ist und zumindest teilweise aus einem magnetisch nur gering-leitfähigen Material wie beispielsweise Messing oder Titan hergestellt ist. Die Antriebswelle ist zwei- oder mehrstückig ausgebildet, so dass die Antriebswelle über ihre axiale Längserstreckung aus mehreren separat ausgebildeten Wellenteilstücken besteht. Dadurch kann die Antriebswelle in relativ einfacher Weise über ihre axiale Länge unterschiedliche Leitfähigkeiten aufweisen. Insbesondere kann die Antriebswelle in einem der Messeinheit zugewandten axialen Bereich eine geringere magnetische und/oder elektrische Leitfähigkeit aufweisen als in einem der Messeinheit abgewandten axialen Bereich. Zur Verbindung der einzelnen Wellenteilstücke können diese ineinander greifen und/oder über Hilfsmittel aneinander fixiert sein. Der erste Wellenendbereich ist durch das erste Wellenteilstück gebildet, das nur eine geringe magnetische Leitfähigkeit aufweist. Dazu ist das erste Wellenteilstück beispielsweise aus Messing hergestellt. Das zweite Wellenteilstück kann dagegen magnetisch leitfähig sein und beispielsweise aus Stahl hergestellt sein. Das zweite Wellenteilstück kann somit eine relativ kostengünstige, typische Standardwelle eines Antriebsstrangs sein. Durch die Ausbildung des magnetisch nur gering-leitfähigen Materials in dem ersten Wellenendbereich kann eine Weiterleitung eines in der Antriebswelle induzierten Magnetfeldes zumindest in dem Bereich des freien Endes, an dem die Messeinheit angeordnet ist, verhindert werden. Insbesondere kann dadurch eine Übertragung einer magnetischen Störgröße in axialer Richtung durch die Antriebswelle verhindert werden und die Messeinheit somit magnetisch abgeschirmt werden. Ferner kann dadurch ein in der Antriebswelle induziertes Magnetfeld bereits in einem der axialen Länge des ersten Wellenendbereichs entsprechenden definierten axialen Abstand zu der Messeinheit in der Antriebswelle konzentriert und abgeleitet werden. Insbesondere kann eine Ableitung eines in der Antriebswelle erzeugten Magnetfelds mittels eines Abschirmkörpers nach radial außen hin ermöglicht sein. Dadurch kann die Antriebswelle zumindest in dem ersten Wellenendbereich nahezu vollständig magnetisch isoliert werden, so dass dieser Bereich für eine Kopplung der Messeinheit an der Antriebswelle besonders geeignet ist.

Erfindungsgemäß ist ein Abschirmkörper zur Abschirmung gegenüber von außen erzeugten Magnetfeldern vorhanden. Der Abschirmkörper ist aus einem magnetisch besonders leitfähigen Material hergestellt, um insbesondere ein in der Antriebswelle vorhandenes Magnetfeld effektiv ableiten zu können. Der Abschirmkörper weist einen axialen Zylinderabschnitt auf, der zumindest teilweise einen Innenraum radial umgibt, in dem die Erregereinheit angeordnet ist. Der Abschirmkörper weist ferner eine innere radiale Übertragungsfläche auf, die die Antriebswelle umgibt, wobei zwischen der Übertragungsfläche des Abschirmkörpers und der Antriebswelle ein definierter Luftspalt ausgebildet ist, derart, dass die Antriebswelle innerhalb des Abschirmkörpers frei drehbar ist und eine Magnetfeldübertragung von der Antriebswelle auf den Abschirmkörper ermöglicht ist. Der radiale Abstand zwischen der Antriebswelle und dem Abschirmkörper kann über die axiale Länge konstant sein. Dadurch kann eine großflächige und gleichmäßige Übertragung eines Magnetfeldes von der Antriebswelle in Richtung des Abschirmkörpers bewirkt werden. Ferner kann bei einer Montage der Abschirmkörper in relativ einfacher Weise über die Antriebswelle aufgesetzt werden. Der Abschirmkörper kann feststehend und insbesondere als ein Außengehäuse zumindest der Messeinheit ausgebildet sein. Folglich kann ein in den rotierenden Bauteilen des Drehwinkelmesssystems erzeugtes Magnetfeld an einer Übergabestelle an zumindest ein feststehendes Bauteil, insbesondere an den Abschirmkörper, übertragen werden. Dadurch kann die Fläche zur Abschirmung vergrößert werden, ohne dass zusätzliche rotierende Bauteile und ein damit verbundenes zusätzliches Mehrgewicht an der Antriebswelle erforderlich sind. Ferner kann eine effektive Abschirmung gegenüber einem von außen erzeugten Magnetfeld geschaffen werden.

Die einzelnen Wellenteilstücke können koaxial miteinander verbunden sein. Für eine besonders stabile und knicksichere Verbindung der beiden Wellenteilstücke, können das erste Wellenteilstück und das zweite Wellenteilstück sich zumindest teilweise radial überschneiden. Insbesondere kann das erste Wellenteilstück einen axial hervorstehenden Zapfen oder Kupplungsabschnitt aufweisen, der von dem zweiten Wellenteilstück zumindest teilweise radial umgeben ist bzw. der in eine korrespondierende Ausnehmung des zweiten Wellenteilstücks axial eingeschoben werden kann. Dadurch sind eine erhöhte Stabilität der Verbindung sowie eine zumindest bereichsweise axiale und radiale magnetische Abschirmung des ersten Wellenteilstücks ermöglicht. Selbstverständlich kann auch das zweite Wellenteilstück einen axial hervorstehenden Zapfen aufweisen, der in eine korrespondierende Ausnehmung des ersten Wellenteilstücks eingeführt ist.

Vorzugsweise sind das erste Wellenteilstück und das zweite Wellenteilstück drehfest miteinander verbunden. Die Fixierung bzw. Befestigung der beiden Wellenteilstücke aneinander erfolgt vorzugsweise über eine Reibschweißung. Dadurch kann die Drehbewegung des zweiten Wellenteilstücks direkt auf das erste Wellenteilstück übertragen werden, so dass eine exakte Messung der Drehbewegung der Antriebswelle ermöglicht ist. Somit können das erste Wellenteilstück und das zweite Wellenteilstück insbesondere stoffschlüssig miteinander verbunden sein, beispielsweise über eine Reibschweißung an den sich gegenüberliegenden axialen Stirnseiten der Wellenteilstücke. Alternativ oder zusätzlich können das erste Wellenteilstück und das zweite Wellenteilstück formschlüssig miteinander verbunden sein, beispielsweise über eine Steckverbindung, bei der die Wellenteilstücke sich zumindest teilweise radial überschneiden können, und beispielsweise über eine radial eingeführte Madenschraube gesichert sind. Ferner können das erste Wellenteilstück und das zweite Wellenteilstück kraftschlüssig, beispielsweise über eine Keil- und/oder Schraubverbindung, miteinander verbunden sein. Darüber hinaus ist auch eine Kombination der zuvor genannten Verbindungsarten möglich. Somit kann eine besonders stabile und kompakte Bauweise des Drehwinkelmesssystems erreicht werden.

In einer Ausgestaltung der Erfindung ist der erste Wellenendbereich durch eine Befestigungseinrichtung gebildet, insbesondere durch eine magnetisch nur gering-leitfähige Schraube. Beispielsweise ist die Befestigungseinrichtung aus Titan oder Messing hergestellt, so dass eine Weiterleitung des in der Antriebswelle oder einem Wellenabschnitt induzierten Magnetfeldes durch die Befestigungseinrichtung hin zu der Erregereinheit verhindert werden kann. Die Befestigungseinrichtung kann dazu dienen, die Erregereinheit mit der Antriebswelle zu koppeln bzw. an der Antriebswelle zu befestigen. Dazu ist die Befestigungseinrichtung vorteilhafterweise an dem der Messeinheit zugewandten stirnseitigen Ende der Antriebswelle angeordnet. Zur Fixierung der Erregereinheit an der Antriebswelle und zur Vermeidung einer unerwünschten Weiterleitung von magnetischen Störgrößen von der Antriebswelle in Richtung der Erregereinheit kann an dem axialen Ende der Antriebswelle zwischen der Erregereinheit und der Antriebswelle zusätzlich ein Abstandshalter bzw. eine Abstandshülse vorgesehen sein, der bzw. die aus einem magnetisch nur gering-leitfähigen Material besteht. Die Befestigungseinrichtung kann mit der Antriebswelle insbesondere drehfest verbunden sein. Zur Anordnung der beispielsweise als eine axiale Schraube ausgebildeten Befestigungseinrichtung kann in der Antriebswelle eine Bohrung ausgebildet sein, wobei die Bohrung vorzugsweise koaxial zu der Antriebswelle ist und ein mit der Schraube korrespondierendes Gewinde aufweist. Dadurch kann die Erregereinheit in relativ einfacher Weise an dem freien Ende der Antriebwelle montiert werden. Zusätzlich oder alternativ kann ein Verkleben der Erregereinheit an der Antriebswelle vorgesehen sein. Dadurch kann das Drehwinkelmessesystem besonders kompakt und kostengünstig sein.

Der Abschirmkörper kann zumindest einen axialen Lagerabschnitt aufweisen, an dem ein Lager der Antriebswelle anliegt. Beispielsweise weist der Abschirmkörper einen Absatz auf, an dem ein Wellenlager der Antriebswelle anliegt. Dadurch ist eine genaue Ausrichtung des Drehwinkelmesssystems bzw. der Messeinheit bezüglich der Antriebswelle sowie ein platzsparender Aufbau ermöglicht.

Der Abschirmkörper kann zumindest einen Absatz aufweisen, an dem die Sensoreinheit und/oder ein Gehäuse befestigt sind. Beispielsweise kann an dem Abschirmkörper ein Flansch mit einem Schraubenlochmuster ausgebildet sein, an dem das Gehäuse mit einem korrespondierenden Gegenflansch und einem korrespondierenden Schraubenlochmuster mittels Schrauben befestigt ist. Der Abschirmkörper kann seinerseits ebenfalls über diesen oder einen weiteren Absatz beispielsweise maschinenseitig festlegbar sein. Darüber hinaus kann an dem Abschirmkörper ein Absatz oder Steg zum Befestigen der Sensoreinheit vorgesehen sein. Insbesondere weist der Abschirmkörper einen Absatz auf, an dem ein Sensorträger axial eingesetzt und befestigt werden kann. Dadurch können zum Einen die Komponenten des Drehwinkelmesssystems zueinander ausgerichtet werden, so dass ein zwischen rotierenden und feststehenden Komponenten ausgebildeter Luftspalt relativ klein sein kann, zum Anderen kann das Drehwinkelmesssystem relativ platzsparend aufgebaut sein.

Vorzugsweise ist ein Gehäuse oder Gehäusedeckel vorgesehen, das bzw. der das Drehwinkelmesssystem zumindest teilweise umgibt. Insbesondere die Messeinheit und der Abschirmkörper können von dem Gehäuse axial und/oder radial umgeben sein. Das Gehäuse ist bevorzugt aus Stahl hergestellt. Dadurch ist eine besonders effektive Abschirmung der Messeinheit bzw. des Drehwinkelmesssystems gegenüber Störgrößen ermöglicht, die außen an dem Drehwinkelmesssystem auftreten und das Drehwinkelmesssystem negativ beeinflussen können.

Das Gehäuse ist bevorzugt auf den Abschirmkörper axial aufsetzbar. Vorzugsweise ist das Gehäuse als ein Topf ausgebildet, der axial über das Drehwinkelmesssystems, insbesondere die Messeinheit, aufgesetzt werden kann. Dadurch sind eine effektive Abschirmung sowie eine relativ einfache Montage des Drehwinkelmesssystems ermöglicht.

Die Erregereinheit kann einen Magnetträger mit zumindest einem an dem Magnetträger festgelegten Magneten aufweisen. Insbesondere bei der Anordnung von zwei separat ausgebildeten Magneten ist der Magnetträger vorgesehen. Dadurch ist eine relativ einfache und kostengünstige Herstellung und Montage der Erregereinheit geschaffen. Der Magnetträger kann eine flach ausgebildete Scheibe sein, die bevorzugt magnetisch nur gering-leitfähig ist. Dadurch kann eine Doppelabschirmung bewirkt werden, die ein Magnetfeldsystem genau definiert, so dass die magnetischen Verhältnisse am Sensor, insbesondere einem Wiegandsensor, sichergestellt und eine Multiturnfunktionalität des Sensors ermöglicht werden.

In einer anderen Ausgestaltung der Erfindung ist die Erregereinheit durch einen Magnet bzw. Magnetkörper gebildet. Der Magnetkörper kann als ein diametral magnetisierter Rundmagnet ausgebildet sein. Dadurch kann auf einen separat ausgebildeten Magnetträger verzichtet werden und das Drehwinkelmesssystem sehr kompakt aufgebaut sein.

Die Erregereinheit, insbesondere der Magnetträger oder der Magnetkörper selbst, kann mittels Verklebung unmittelbar an dem ersten Wellenendbereich der Antriebswelle befestigt sein. Insbesondere kann die Erregereinheit an der axialen Stirnseite der Antriebswelle angeklebt sein. Bei dieser Ausgestaltung ist der erste Wellenendbereich bevorzugt durch ein magnetisch nur gering-leitfähiges Wellenteilstück gebildet. Durch die Klebverbindung der Erregereinheit unmittelbar an der Antriebswelle kann das Drehwinkelmesssystem sehr kompakt aufgebaut sein.

Um die Festigkeit der Verbindung zwischen der Erregereinheit und der Antriebswelle zu Erhöhen und/oder um eine Verdrehsicherheit der Erregereinheit gegenüber der Antriebswelle zu gewährleisten, kann an dem ersten Wellenendbereich an der Antriebswelle eine Ausnehmung vorgesehen sein, in die die Erregereinheit, insbesondere der Magnetträger bzw. der Magnet, zumindest teilweise eingesetzt werden kann. Alternativ kann an dem ersten Wellenendbereich an der Antriebswelle eine Außenkontur vorgesehen sein, auf die die Erregereinheit zumindest teilweise aufsetzbar ist. Die Ausnehmung bzw. Außenkontur kann koaxial und zylindrisch oder eckig an der Antriebselle ausgebildet sein. Die Ausnehmung bzw. Außenkontur dient insbesondere zur Oberflächenvergrößerung der Klebeflächen. Zudem kann bei einer eckig ausgebildeten Ausnehmung oder Außenkontur, in die die Erregereinheit mit einem korrespondierenden eckig ausgebildeten Teil ein- bzw. aufgesetzt wird, eine Drehfestigkeit der Erregereinheit gegenüber der Antriebswelle durch Formschluss bewirkt werden.

Nachfolgend wird die Erfindung anhand drei bevorzugter Ausführungsformen unter Bezugnahme auf die anliegenden Zeichnungen näher erläutert.
Figur 1 zeigt schematisch eine perspektivische Ansicht einer ersten erfindungsgemäßen Ausführung eines Drehwinkelmesssystems, wobei die Bauteile gesprengt dargestellt sind,
Figur 2 zeigt schematisch einen Ausschnitt der ersten Ausführung in einer seitlichen Schnittansicht,
Figur 3 zeigt schematisch einen Ausschnitt einer zweiten erfindungsgemäßen Ausführung eines Drehwinkelmesssystems in einer seitlichen Schnittansicht, und
Figur 4 zeigt schematisch einen Ausschnitt einer weiteren erfindungsgemäßen Ausführung eines Drehwinkelmesssystems in einer seitlichen Schnittansicht.

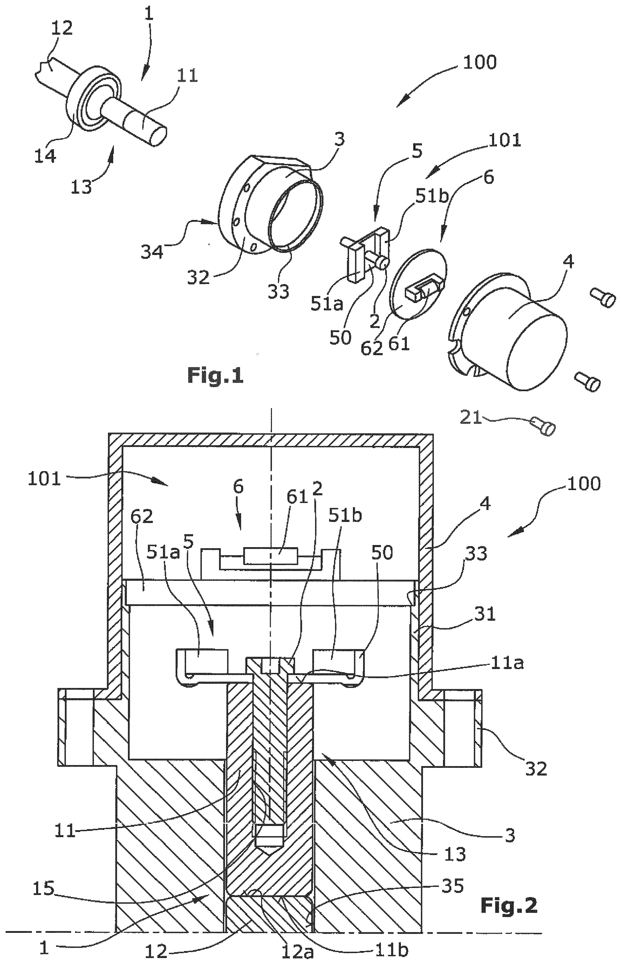

In den Figuren 1 bis 3 ist jeweils ein Drehwinkelmesssystem 100 mit einer Messeinheit 101 gezeigt, die unmittelbar an eine Antriebswelle 1 gekoppelt werden kann. Die Messeinheit 101 umfasst insbesondere eine Erregereinheit 5 und eine Sensoreinheit 6 und ist an einem axialen ersten Wellenendbereich 13 der Antriebswelle 1 angeordnet. Das Drehwinkelmesssystem 100 ist bei allen gezeigten Ausführungsformen im Wesentlichen gleich aufgebaut, wobei die Unterschiede der einzelnen Ausführungen insbesondere in der Ausgestaltung der Antriebswelle 1 liegen.

Die Antriebswelle 1 ist üblicherweise als eine Vollwelle ausgebildet, die im Betrieb zumindest teilweise magnetisiert werden kann. Eine solche Magnetsierung der Antriebswelle 1 kann beispielsweise durch einen in den Figuren 1 bis 3 nicht dargestellten Elektromotor oder eine magnetische Bremse erfolgen. Solche Vorrichtungen, wie ein Elektromotor, sind üblicherweise in einem der Messeinheit 101 abgewandten Bereich der Antriebswelle 1 angeordnet, vorliegend an einem Wellenteilstück 12. Um mögliche Messfehler, die aufgrund einer Magnetisierung der Antriebswelle 1 entstehen können, zu vermeiden, ist eine Abschirmung der Messeinheit 101 gegenüber solchen Magnetfeldern erforderlich. Vorliegend wird eine solche Abschirmung insbesondere durch die Ausgestaltung der Antriebswelle 1 sowie durch die Anordnung eines Abschirmkörpers 3 bewirkt, so dass unerwünschte Magnetfelder effektiv von der Messeinheit 101 abgelenkt werden können.

Der Abschirmkörper 3 ist zylindrisch ausgebildet, feststehend und aus einem magnetisch leitfähigen Material hergestellt, beispielsweise aus Eisen oder Stahl. Der Abschirmkörper 3 umgibt die Antriebswelle 1 zumindest in einem Teilbereich. Zwischen der Antriebswelle 1 und dem Abschirmkörpers 3 ist ein definierter radialer Abstand ausgebildet, so dass die Antriebswelle 1 innerhalb des Abschirmkörpers 3 frei drehbar ist und eine Magnetfeldübertragung von der Antriebswelle 1 auf den Abschirmkörper 3 ermöglicht ist. Dazu weist der Abschirmkörper 3 eine die Antriebswelle 1 umgebende innere radiale Übertragungsfläche 35 auf. Dadurch kann ein in der Antriebswelle 1 induziertes Magnetfeld in relativ einfacher Weise von der Antriebswelle 1 nach radial außen in den Abschirmkörper 3 und weiter in ein Gehäuse 4 übertragen werden. Der Abschirmkörpers 3 weist einen inneren axialen Absatz sowie einen sich daran anschließenden axialen Zylinderabschnitt 31 auf, der zumindest teilweise einen Innenraum radial umgibt, in dem die Erregereinheit 5 angeordnet ist. Dadurch kann die Erregereinheit 5 besonders effektiv gegen magnetische Störgrößen abgeschirmt werden. An einer radialen Außenseite des Abschirmkörpers 3 ist ein Flansch 32 zur Befestigung des Gehäuses 4 an dem Abschirmkörpers 3 und/oder zur Befestigung des gesamten Drehwinkelmesssystems 100 an einer nicht dargestellten Maschine vorgesehen. Ferner kann der Abschirmkörper 3 - wie insbesondere in Figur 1 gezeigt - einen axialen Lagerabschnitt 34 aufweisen, an dem ein Lager 14 der Antriebswelle 1 anliegt. Dadurch ist eine genaue Ausrichtung der Messeinheit 101 bezüglich der Antriebswelle 1 ermöglicht.

Die Erregereinheit 5 umfasst einen Magnetträger 50, an dem zwei Permanentmagnete 51a, 51b befestigt sind. Die Erregereinheit 5 ist über ein Befestigungsmittel 2, vorliegend eine Schraube, drehfest mit der Antriebswelle 1 verbunden, insbesondere mit einem magnetisch nur gering-leitfähigen ersten Wellenteilstück 11 der Antriebswelle 1. Dadurch können die Magnete 51a, 51b im Betrieb ein der Umdrehung der Antriebswelle 1 entsprechendes, rotatorisches Magnetfeld aufbauen, welches von der Sensoreinheit 6 erfasst werden kann. Um eine Weiterleitung eines Magnetfelds auf den Magnetträger 50 effektiv zu vermeiden, ist die Schraube 2 bevorzugt aus einem magnetisch nur gering-leitfähigen Material hergestellt.

Die Sensoreinheit 6 ist feststehend und umfasst insbesondere einen an einem Sensorträger 62 befestigten Sensor 61, beispielsweise einen Hall-und/oder Wiegand-Sensor. Der Sensor 61 kann zur Erfassung einer jeden Umdrehung der Antriebswelle 1 geeignet sein. Die Sensoreinheit 6 kann ferner eine nicht dargestellte Verarbeitungselektronik umfassen. Der Sensorträger 62 ist als eine runde Scheibe ausgebildet, die im montierten Zustand an einem Absatz 33 des Abschirmkörpers 3 anliegt. Der Sensorträger 62 bildet dadurch einen Deckel für die innerhalb des Abschirmkörpers 3 angeordnete Erregereinheit 5.

Ein feststehendes Gehäuse 4 umgibt schließlich sowohl den Abschirmkörper 3 als auch zumindest teilweise die Messeinheit 101. Dabei kann das Gehäuse 4 zylindrisch aufgebaut sein und in einfacher Weise über einen Zylinderabschnitt 31 des Abschirmkörpers 3 aufgesteckt und mittels nicht dargestellten Schrauben an dem Flansch 32 des Abschirmkörpers 3 befestigt werden. Das Gehäuse 4 kann aus Stahl hergestellt sein, so dass ein Magnetfeld von dem Abschirmkörper 3 in das Gehäuse 4 übertragbar ist. Dadurch ist eine besonders effektive magnetische Abschirmung der Messeinheit 101 ermöglicht.

In den Figuren 1 und 2 ist eine erste Ausgestaltung der Erfindung gezeigt, bei der die Antriebswelle 1 zumindest zweiteilig ausgebildet ist. Insbesondere ist die Antriebswelle 1 durch ein separat ausgebildetes erstes Wellenteilstück 11 und ein separat ausgebildetes zweites Wellenteilstück 12 gebildet, wobei die Wellenteilstücke 11, 12 drehfest aneinander fixiert sind.

Das erste Wellenteilstück 11 ist in einem der Messeinheit 101 zugewandten ersten Wellenendbereich 13 angeordnet, magnetisch nur gering-leitfähig und gegenüber dem zweiten Wellenteilstück 12 wesentlich kürzer ausgebildet. Das zweite Wellenteilstück 12 ist an einem der Messeinheit 101 abgewandten zweiten Wellenendbereich angeordnet und kann magnetisch leitfähig sein. Das zweite Wellenteilstück 12 kann sich dabei axial bis in einen nicht dargestellten Elektromotor oder eine magnetische Bremse erstrecken.

Das erste Wellenteilstück 11 liegt mit einer der Messeinheit 101 abgewandten Stirnseitenfläche 11b an einer der Messeinheit 101 zugewandten Stirnseitenfläche 12a des zweiten Wellenteilstücks 12 an, wobei die Stirnseitenflächen 11b, 12a vorliegend mittels einer Reibschweißung zueinander fixiert sind. Das erste Wellenteilstück 11 und das zweite Wellenteilstück 12 weisen jeweils den gleichen Außendurchmesser auf und sind koaxial zueinander ausgerichtet, so dass die beiden Wellenteilstücke 11, 12 eine im Wesentlichen ohne Ausbildung eines axialen Absatzes ausgebildete gesamte Antriebswelle 1 bilden. Dadurch kann die Antriebswelle 1 in relativ einfacher Weise montiert werden.

Das erste Wellenteilstück 11 ist in der in den Figuren gezeigten Ausführungsform als eine Vollwelle ausgebildet. An der der Messeinheit 101 zugewandten Stirnseite 11a, an der der Magnetträger 50 an dem ersten Wellenteilstück 11 anliegt, weist das erste Wellenteilstück 11 eine koaxiale Ausnehmung 15 auf, die in der Figur 1 durch eine zylindrische Bohrung gebildet ist. In der Bohrung 15 ist ein Gewinde zur Aufnahme der Schraube 2 ausgebildet. Die Schraube 2 erstreckt sich durch den Magnetträger 50 bis in das erste Wellenteilstück 11 der Antriebswelle 1, so dass die Erregereinheit 5 an der Antriebswelle 1 festgelegt ist. Die Schraube 2 ist - wie auch das erste Wellenteilstück 11 - aus einem magnetisch nur geringfügig-leitfähigen Material hergestellt. Beispielsweise weist das erste Wellenteilstück 11 und/oder die Schraube 2 eine Titan-Aluminium-Vanadium-Legierung auf, so dass ein in dem zweiten Wellenteilstück 12 der Antriebswelle 1 induziertes Magnetfeld in dem Wellenendbereich 13 der Antriebswelle 1 nicht durch das erste Wellenteilstück 11 und/oder die Schraube 2 weitergeleitet wird.

In einer nicht dargestellten alternativen Ausgestaltung der Erfindung ist das erste Wellenteilstück 11 über dessen axiale Längserstreckung hohl ausgebildet, das heißt als eine Hülse. Die Bohrung 15 ist in diesem Fall an der dem ersten Wellenteilstück 11 zugewandten Stirnseite 12a des zweiten Wellenteilstück 12 ausgebildet, so dass die Schraube 2 sich durch den Magnetträger 50, das als Hülse ausgebildete erste Wellenteilstück 11 bis in das zweite Wellenteilstück 12 erstreckt. Zwischen der Schraube 2 und der Hülse kann dabei ein radialer Abstand ausgebildet sein. Zur Steigerung der Stabilität ist in dieser Ausgestaltung der Außendurchmesser des ersten Wellenteilstücks 11 bevorzugt geringer als der des zweiten Wellenteilstücks 12.

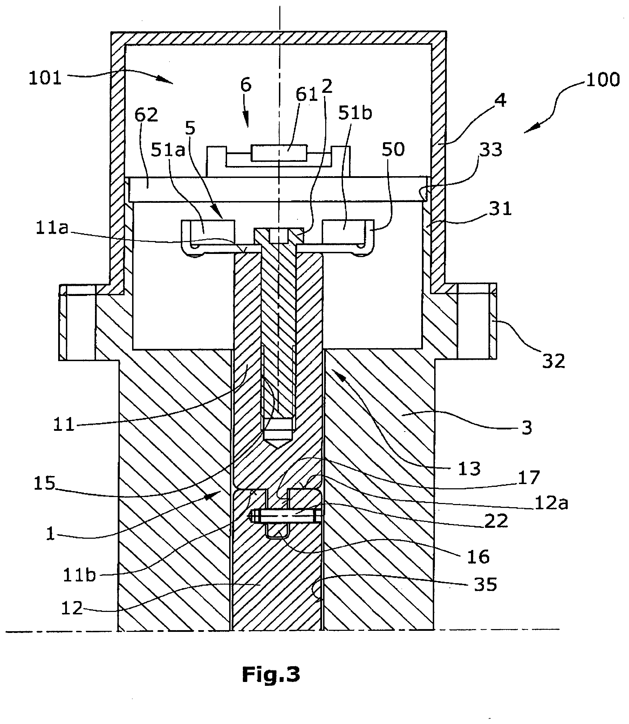

In der Figur 3 ist eine zweite Ausgestaltung der Erfindung gezeigt, die im Wesentlichen der hinsichtlich der Figuren 1 und 2 beschriebenen Ausgestaltung entspricht, wobei an der Verbindungsstelle zwischen dem erste Wellenteilstück 11 und dem zweiten Wellenteilstück 12 der Antriebswelle 1 zur Steigerung der Stabilität eine zusätzliche Zapfenverbindung angeordnet ist. Insbesondere weist das erste Wellenteilstück 11 an einer dem zweiten Wellenteilstück 12 zugewandten axialen Stirnseite 11b einen axial hervorstehenden Zapfen 16 auf, der in eine an dem zweiten Wellenteilstück 12 ausgebildete korrespondiere Ausnehmung 17 eingefügt ist. In der Figur 3 sind der Zapfen 16 und die mit diesem korrespondierende Ausnehmung 17 zylindrisch ausgebildet und koaxial an dem jeweiligen Wellenteilstück 11, 12 ausgebildet. Der Zapfen 16 und die Ausnehmung 17 können alternativ auch anderweitig, beispielsweise eckig, ausgebildet sein und/oder exzentrisch an der jeweiligen Stirnseite 11b, 12a angeordnet sein. Zur Sicherung des ersten Wellenteilstücks 11 gegenüber dem zweiten Wellenteilstück 12 ist eine Madenschraube 22 vorgesehen, die sich in einer radialen Bohrung zumindest teilweise durch das zweite Wellenteilstück 12 sowie den Zapfen 16 des ersten Wellenteilstücks 11 erstreckt. Selbstverständlich kann der Zapfen 16 auch an dem zweiten Wellenteilstück 12 und eine korrespondierende Ausnehmung 17 an dem ersten Wellenteilstück 11 angeordnet sein.

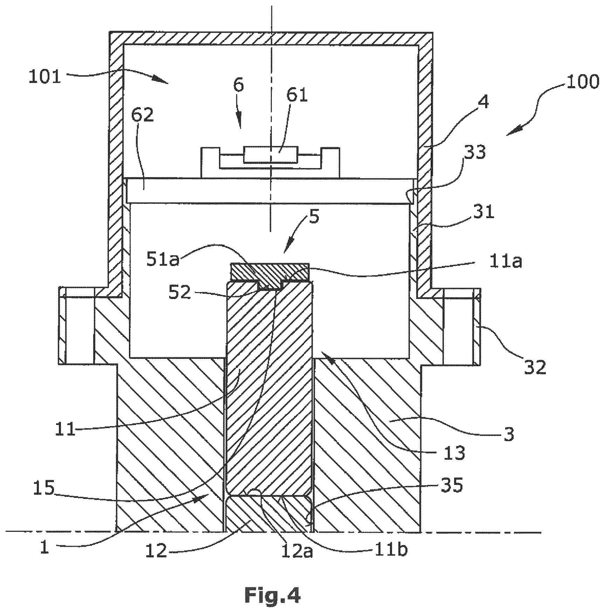

In der Figur 4 ist eine weitere Ausgestaltung der Erfindung gezeigt, die wiederum grundsätzlich einer der in den Figuren 1 bis 3 beschriebenen Ausgestaltung entspricht, wobei in dieser Ausgestaltung die Erregereinheit 5 durch lediglich einen einzigen Magnetkörper 51a gebildet ist und unmittelbar an der der Messeinheit 101 zugewandten Stirnseite 11a an dem Wellenendbereich 13 der Antriebswelle 1 angeordnet ist. Der Magnetkörper 51a ist insbesondere als ein diametral magnetisierter Rundmagnet ausgebildet und an einem axialen Ende eines ersten, magnetisch nur gering-leitfähigen Wellenteilstücks 11 über eine Klebverbindung an der Antriebswelle 1 befestigt. Zur Steigerung der Festigkeit ist der Magnetkörper 51a zusätzlich mit einem axial hervorstehenden Magnetzapfen 52 in eine an der Antriebswelle 1 ausgebildete Ausnehmung 15 zumindest teilweise eingesetzt. In der Figur 4 sind der Magnetzapfen 52 und die mit diesem korrespondierende Ausnehmung 15 zylindrisch ausgebildet und koaxial ausgebildet. Der Magnetzapfen 52 und die Ausnehmung 15 können alternativ auch anderweitig, beispielsweise eckig, ausgebildet und/oder exzentrisch an dem Magnetkörper 51a und der Antriebswelle 1 angeordnet sein. Dadurch kann insbesondere eine Verdrehsicherheit des Magnetkörpers 51a gegenüber der Antriebswelle 1 ermöglicht sein. Alternativ kann auch der gesamte, beispielsweise als diametral magnetisierter Rundmagnet ausgebildete Magnetkörper 51a in eine korrespondierende Ausnehmung 15 axial eingesetzt sein. Hierbei kann auf den axial hervorstehenden Magnetzapfen verzichtet werden, In den hinsichtlich der Figur 4 gezeigten und/oder beschriebenen Ausführungen der Erfindung kann insbesondere auf einen separat ausgebildeten Magnetträger sowie auf eine Schraube zur Befestigung des Magnets 51a an der Antriebswelle 1 verzichtet werden.

Folglich ist mit dem Drehwinkelmesssystem 100 eine exakte und störungsfreie Messung, ein relativ einfacher und kompakter Aufbau sowie eine unkomplizierte Montage ermöglicht.

### Bezugszeichen

- 100: Drehwinkelmesssystem
- 101: Messeinheit

- 1: Antriebswelle
- 11: erstes Wellenteilstück
- 11a: Stirnseite
- 11b: Stirnseite
- 12: zweites Wellenteilstück
- 13: erster Wellenendbereich, erstes freies Ende
- 14: Wellenlager
- 15: Ausnehmung, Bohrung mit Gewinde
- 16: Zapfen
- 17: Ausnehmung

- 2: Befestigungseinrichtung, Schraube
- 21: Schraube
- 22: Schraube

- 3: Abschirmkörper
- 31: Zylinder
- 32: Absatz, Steg, Flansch
- 33: Absatz, Steg, Flansch
- 34: Lagerabschnitt
- 35: radiale Übertragungsfläche

- 4: Gehäuse

- 5: Erregereinheit
- 50: Magnetträger

- 51a: Permanentmagnet, Magnet
- 51b: Permanentmagnet, Magnet
- 52: Magnetzapfen

- 6: Sensoreinheit
- 61: Sensor
- 62: Sensorträger

## Patentansprüche

1. Magnet-basiertes Drehwinkelmesssystem (100) zum Erfassen einer Drehbewegung einer Antriebswelle (1), mit
einer Antriebswelle (1), die zumindest zweistückig ausgebildet ist und ein separat ausgebildetes erstes Wellenteilstück (11), ein separat ausgebildetes zweites Wellenteilstück (12) und einen axialen ersten Wellenendbereich (13) aufweist, wobei der erste Wellenendbereich (13) durch das erste Wellenteilstück (11) gebildet ist und zumindest teilweise aus einem magnetisch nur gering-leitfähigen Material wie beispielsweise Messing oder Titan hergestellt ist,
einer an dem ersten Wellenendbereich (13) mit der Antriebswelle (1) drehfest verbundenen Erregereinheit (5), und
einer feststehenden Sensoreinheit (6), die zum Erfassen einer Drehbewegung der Antriebswelle (1) mit der Erregereinheit (5) funktional zusammenwirkt,
**dadurch gekennzeichnet, dass**
ein Abschirmkörper (3) zur Abschirmung gegenüber von außen erzeugten Magnetfeldern vorhanden ist, der
- aus einem magnetisch besonders leitfähigen Material hergestellt ist,
- einen axialen Zylinderabschnitt (31) aufweist, der zumindest teilweise einen Innenraum radial umgibt, in dem die Erregereinheit (5) angeordnet ist, und
- eine innere radiale Übertragungsfläche (35) aufweist, die die Antriebswelle (1) umgibt,
wobei zwischen der Übertragungsfläche (35) und der Antriebswelle (1) ein definierter Luftspalt ausgebildet ist, derart, dass die Antriebswelle (1) innerhalb des Abschirmkörpers (3) frei drehbar ist und eine Magnetfeldübertragung von der Antriebswelle (1) auf den Abschirmkörper (3) ermöglicht ist.

2. Magnet-basiertes Drehwinkelmesssystem (100) nach Anspruch 1, wobei das erste Wellenteilstück (11) und das zweite Wellenteilstück (12) sich zumindest teilweise radial überschneiden.

3. Magnet-basiertes Drehwinkelmesssystem (100) nach einem der voranstehenden Ansprüche, wobei das erste Wellenteilstück (11) und das zweite Wellenteilstück (12) drehfest miteinander verbunden sind.

4. Magnet-basiertes Drehwinkelmesssystem (100) nach einem der voranstehenden Ansprüche, wobei der erste Wellenendbereich (13) durch eine Befestigungseinrichtung (2) gebildet ist.

5. Magnet-basiertes Drehwinkelmesssystem (100) nach einem der voranstehenden Ansprüche, wobei der Abschirmkörper (3) einen axialen Lagerabschnitt (34) aufweist, an dem ein Lager (14) der Antriebswelle (4) anliegt.

6. Magnet-basiertes Drehwinkelmesssystem (100) nach einem der voranstehenden Ansprüche, wobei der Abschirmkörper (3) zumindest einen Absatz (32, 33) aufweist, an dem die Sensoreinheit (6) und/oder ein Gehäuse (4) festlegbar sind.

7. Magnet-basiertes Drehwinkelmesssystem (100) nach einem der voranstehenden Ansprüche, wobei ein Gehäuse (4) vorgesehen ist, das das Drehwinkelmesssystem (100) zumindest teilweise umgibt.

8. Magnet-basiertes Drehwinkelmesssystem (100) nach Anspruch 7, wobei das Gehäuse (4) auf den Abschirmkörper (3) axial aufsetzbar ist.

9. Magnet-basiertes Drehwinkelmesssystem (100) nach einem der voranstehenden Ansprüche, wobei die Erregereinheit (5) einen Magnetträger (50) mit zumindest einem an dem Magnetträger (50) festgelegten Magnet (51a, 51b) aufweist.

10. Magnet-basiertes Drehwinkelmesssystem (100) nach einem der voranstehenden Ansprüche, wobei die Erregereinheit (5) durch einen Magnet (51a) gebildet ist.

11. Magnet-basiertes Drehwinkelmesssystem (100) nach einem der voranstehenden Ansprüche, wobei dass die Erregereinheit (5) mittels Verklebung an dem ersten Wellenendbereich (13) der Antriebswelle (1) befestigt ist.

12. Magnet-basiertes Drehwinkelmesssystem (100) nach einem der voranstehenden Ansprüche, wobei die Antriebswelle (1) an dem ersten Wellenendbereich (13) eine Ausnehmung (15) aufweist, in die die Erregereinheit (5) zumindest teilweise eingesetzt ist.

## Claims

1. Magnet-based angular displacement measuring system (100) for detecting a rotational movement of a drive shaft (1), comprising
a drive shaft (1) which is composed of at least two parts and which comprises a separately formed first shaft part (11), a separately formed second shaft part (12) and an axial first shaft end region (13), wherein the first shaft end region (13) is defined by the first shaft part (11) and is made at least in part of a material of low magnetic conductivity, such as brass or titanium,
an exciter unit (5) which is co-rotationally coupled to the first shaft end region (13) of the drive shaft (1), and
a static sensor unit (6) which functionally interacts with the exciter unit (5) for detecting the rotational movement of the drive shaft (1),
**characterized in that**
a shielding body (3) is provided for shielding against magnetic field generated externally, the shielding body (3)
- being made of a magnetically particularly conductive material,
- comprising an axial cylindrical section (31) which at least in part radially encloses an inner space in which the exciter unit (5) is arranged, and
- comprising an inner radial transfer surface (35) which surrounds the drive shaft (1),
wherein a defined air gap is formed between the transfer surface (35) and the drive shaft (1) such that the drive shaft (1) is freely rotatable within the shielding body (3) and that a magnetic field transfer from the drive shaft (1) to the shielding body (3) is possible.

2. Magnet-based angular displacement measuring system (100) of claim 1, wherein the first shaft part (11) and the second shaft part (12) overlap each other radially at least in part.

3. Magnet-based angular displacement measuring system (100) of one of the preceding claims, wherein the first shaft part (11) and the second shaft part (12) are co-rotationally connected with each other.

4. Magnet-based angular displacement measuring system (100) of one of the preceding claims, wherein the first shaft end region (13) is defined by a fasting means (2).

5. Magnet-based angular displacement measuring system (100) of one of the preceding claims, wherein the shielding body (3) comprises an axial bearing section (34) which a bearing (14) of the drive shaft (4) abuts.

6. Magnet-based angular displacement measuring system (100) of one of the preceding claims, wherein the shielding body (3) comprises at least one shoulder (32, 33) on which the sensor unit (6) and/or a housing (4) may be fixed.

7. Magnet-based angular displacement measuring system (100) of one of the preceding claims, wherein a housing (4) is provided which surrounds the angular displacement measuring system (100) at least in part.

8. Magnet-based angular displacement measuring system (100) of claim 7, wherein the housing (4) is configured to be axially attachable to the shielding body (3).

9. Magnet-based angular displacement measuring system (100) of one of the preceding claims, wherein the exciter unit (5) comprises a magnet carrier (50) with at least one magnet (51a, 51b) which is fixed to the magnet carrier (50).

10. Magnet-based angular displacement measuring system (100) of one of the preceding claims, wherein the exciter unit (5) is defined by a magnet (51a).

11. Magnet-based angular displacement measuring system (100) of one of the preceding claims, wherein the exciter unit (5) is fastened to the first shaft end region (13) of the drive shaft (1) by adhesive bonding.

12. Magnet-based angular displacement measuring system (100) of one of the preceding claims, wherein the drive shaft (1) has a recess in the first shaft end region (13), into which the exciter unit (5) is inserted at least in part.

## Revendications

1. Système de mesure d'angle de rotation (100) à base d'aimants pour la détection d'un mouvement de rotation d'un arbre d'entrainement (1), comportant
un arbre d'entrainement (1) réalisé en au moins deux parties et comportant une première section d'arbre (11) formée séparément, une deuxième section d'arbre (12) formée séparément et une première région d'extrémité d'arbre (13) axiale, la première région d'extrémité d'arbre (13) étant formée par la première section d'arbre (11) et étant fabriquée au moins partiellement d'un matériau à faible conductivité magnétique, comme par exemple le laiton ou le titanium,
une unité d'excitation (5) reliée de manière fixe en rotation à l'arbre d'entrainement (1) au niveau de la première région d'extrémité d'arbre (13), et
une unité de capteur stationnaire (6) coopérant fonctionnellement avec l'unité d'excitation (5) pour détecter un mouvement de rotation de l'arbre d'entrainement (1),
**caractérisé en ce qu'**un
corps de blindage (3) est prévu pour le blindage de champs magnétiques générés à partir de l'extérieur, ledit corps
- une section de cylindre (31) axiale entourant radialement au moins partiellement un intérieur dans lequel est disposée l'unité d'excitation (5), et
- une surface de transfert (35) interne radiale entourant l'arbre d'entrainement (1),
un entrefer défini étant formé entre la surface de transfert (35) et l'arbre d'entrainement (1) de sorte que l'arbre d'entrainement (1) peut tourner librement dans le corps de blindage (3) et un transfert de champs magnétique de l'arbre d'entrainement (1) au corps de blindage (3) est possible.

2. Système de mesure d'angle de rotation (100) à base d'aimants selon la revendication 1, dans lequel la première section d'arbre (11) et la deuxième section d'arbre (12) se chevauchent au moins partiellement radialement.

3. Système de mesure d'angle de rotation (100) à base d'aimants selon l'une quelconque des revendications précédentes, dans lequel la première section d'arbre (11) et la deuxième section d'arbre (12) sont reliées l'une à l'autre de manière non rotative.

4. Système de mesure d'angle de rotation (100) à base d'aimants selon l'une quelconque des revendications précédentes, dans lequel la première région d'extrémité d'arbre (13) est formée par un moyen de fixation (2).

5. Système de mesure d'angle de rotation (100) à base d'aimants selon l'une quelconque des revendications précédentes, dans lequel le corps de blindage (3) présente une section de palier (34) axiale sur laquelle s'appuie un palier (14) de l'arbre d'entrainement (4).

6. Système de mesure d'angle de rotation (100) à base d'aimants selon l'une quelconque des revendications précédentes, dans lequel le corps de blindage (3) présente au moins un épaulement (32, 33) sur lequel l'unité de détection (6) et/ou un carter (4) peuvent être fixés.

7. Système de mesure d'angle de rotation (100) à base d'aimants selon l'une quelconque des revendications précédentes, dans lequel est prévu un carter (4) entourant le système de mesure à angle rotatif (100) au moins partiellement.

8. Système de mesure d'angle de rotation (100) à base d'aimants selon la revendication 7, dans lequel le carter (4) peut être placé axialement sur le corps de blindage (3).

9. Système de mesure d'angle de rotation (100) à base d'aimants selon l'une quelconque des revendications précédentes, dans lequel l'unité d'excitation (5) comporte un porte-aimant (50) avec au moins un aimant (51a, 51b) fixé sur le porte-aimant (50).

10. Système de mesure d'angle de rotation (100) à base d'aimants selon l'une quelconque des revendications précédentes, dans lequel l'unité d'excitation (5) est formée par un aimant (51a).

11. Système de mesure d'angle de rotation (100) à base d'aimants selon l'une quelconque des revendications précédentes, dans lequel l'unité d'excitation (5) est fixée sur la première région d'extrémité d'arbre (13) de l'arbre d'entrainement (1) par collage.

12. Système de mesure d'angle de rotation (100) à base d'aimants selon l'une quelconque des revendications précédentes, dans lequel l'arbre d'entrainement (1) présente un évidement (15) dans la première région d'extrémité d'arbre (13), dans lequel l'unité d'excitation (5) est au moins partiellement insérée.
